# EUROPÄISCHE PATENTSCHRIFT

(11) **EP 0 891 603 B1**
(45) Veröffentlichungstag und Bekanntmachung des Hinweises auf die Patenterteilung: **23.11.2005**
(21) Anmeldenummer: 97952738.9
(22) Anmeldetag: 18.12.1997
(51) Int. Cl.: G06K 19/077

(54) **NICHT-LEITENDES, EIN BAND ODER EINEN NUTZEN BILDENDES SUBSTRAT, AUF DEM EINE VIELZAHL VON TRÄGERELEMENTEN AUSGEBILDET IST**
NON-CONDUCTIVE SUBSTRATE FORMING A BAND OR PANEL, ON WHICH ARE FORMED A PLURALITY OF SUPPORT ELEMENTS
SUBSTRAT NON CONDUCTEUR FORMANT UNE BANDE OU UN FLANC, SUR LEQUEL SONT FORMES UNE PLURALITE D'ELEMENTS PORTEURS

(30) Priorität: 20.12.1996 DE 19653623
(43) Veröffentlichungstag der Anmeldung: 20.01.1999
(73) Patentinhaber: Infineon Technologies AG, 81669 München (DE)
(72) Erfinder: STAMPKA, Peter, D-92421 Schwandorf (DE); HUBER, Michael, D-93152 Nittendorf (DE); SCHRAUD, Gerhard, D-86415 Mering (DE); STRIEGEL, Peter, D-81825 München (DE); MENSCH, Hans-Georg, D-92431 Neunburg (DE)
(74) Vertreter: Epping - Hermann - Fischer
(86) Internationale Anmeldenummer: PCT/DE1997/002964
(87) Internationale Veröffentlichungsnummer: WO 1998/028709

(56) Entgegenhaltungen:
- EP-A- 0 581 284
- EP-A- 0 671 705
- PATENT ABSTRACTS OF JAPAN vol. 018, no. 304 (M-1619), 10.Juni 1994 & JP 06 064381 A (OKI ELECTRIC IND CO LTD), 8.März 1994,

## Beschreibung

Ein Trägerelement, das aus einem solchen Substrat herausgetrennt ist, ist aus den Figuren 8 und 9 der EP 0 671 705 A2 bekannt. Das dortige Trägerelement ist zum Einbau in eine Chipkarte vorgesehen, die sowohl kontaktbehaftet über eine Anzahl von Kontaktflächen als auch kontaktlos über eine Antennenspule, beispielsweise über transformatorische Kopplung, betrieben werden kann.

Trägerelemente für Chipkarten dienen der mechanischen Halterung des Halbleiterchips und weisen außerdem die zur Kontaktierung des Chips nötigen Kontaktflächen auf. Sie werden sowohl in rein kontaktbehafteten Chipkarten eingesetzt, so daß ein Zugriff auf den Halbleiterchip nur über die Kontaktfläche möglich ist, als auch in sogenannten Kombikarten, bei denen zusätzlich ein kontaktloser Zugriff mittels Leiterschleifen in der Karte und/oder auf dem Trägerelement oder dem Chip möglich ist. Die Leiterschleifen werden zu diesem Zweck mit Spulenanschlüssen des Halbleiterchips verbunden.

Diese Trägerelemente werden üblicherweise nicht einzeln, sondern auf einem langen Band oder einem großflächigen Nutzen aus einem nicht-leitenden Material in großen Stückzahlen hergestellt. Dieses - im folgenden als Substrat bezeichnete - Band oder der Nutzen werden zunächst durch beispielsweise Stanzen von Ausnehmungen strukturiert und dann einseitig mit einer Kupferfolie kaschiert, die anschließend beispielsweise durch Ätzen strukturiert wird, so daß die Kontaktflächen für die einzelnen Trägerelemente gebildet werden. Alle leitenden Strukturen sind zunächst noch durch schmale Leitungen elekrisch leitend miteinander verbunden, um eine galvanische O-berflächenveredelung durchführen zu können.

Die Halbleiterchips werden auf der den Kontaktflächen gegenüberliegenden Seite des Substrats befestigt und mittels Bonddrähte durch die Ausnehmungen elektrisch mit den Kontaktflächen verbunden. Vor einem Funktionstest der Halbleiterchips, der noch im Band oder Nutzen stattfindet, werden die schmalen Leitungen mittels Stanzen durchtrennt, so daß die Kontaktflächen elektrisch voneinander isoliert sind.

Beim Trägerelement der EP 0 671 705 A2 sind die Spulenanschlüsse des Halbleiterchips durch Ausnehmungen im Substrat hindurch mit Kontaktflächen auf der dem Chip gegenüberliegenden Seite des Substrats verbunden. Die Enden einer anzuschließenden Antennenspule werden ebenfalls mit diesen Kontaktflächen durch hierfür vorgesehene Ausnehmungen im Substrat hindurch mit zwei dieser Kontaktflächen verbunden. Die Kontaktflächen dienen also als Verbindungselemente zwischen Spule und Halbleiterchip. Dies hat aber den Nachteil, daß die Spulenanschlüsse des Halbleiterchips von der Kontaktflächenseite her zugänglich sind, auch nachdem die Trägerelemente vereinzelt sind.

In dem Dokument EP 0 581 284 A2 wird eine kontaktlose Chipkarte mit innerhalb der Chipkarte angeordneten integrierten Schaltungseinheiten beschrieben. Auf der Außenseite der Chipkarte befinden sich Testkontaktflächen die mit den Schaltungseinheiten verbunden sind. Während des Testbetriebes sind diese Testkontaktflächen zugänglich. Anschließend werden sie durch ein nicht-leitendes Material abgedeckt.

In den Patent Abstracts of Japan, Band 018, Nr. 304 (M-1619), 10. Juni 1994 (1994-06-10) & JP 06 064381 A (Oki Electric Ind Co Ltd), 8. März 1994 (1994-03-08) ist ein Chipkartenmodul beschrieben, an dessen Oberseite Kontaktflächen angeordnet sind. An der Unterseite sind Testkontaktflächen angeordnet.

Die Testkontaktflächen sind mit Durchkontaktierungen mit den Kontaktflächen auf der Oberseite verbunden, so daß nach Montage des Chips dessen Funktion über die Testkontaktflächen überprüft werden kann, ohne das Modul zu wenden.

Die Aufgabe vorliegender Erfindung ist es daher, ein Trägerelement, das auf einem Substrat hergestellt wird, anzugeben, bei dem die Spulenanschlüsse eines zu montierenden Halbleiterchips von der Kontaktflächenseite her zugänglich sind, solange das Trägerelement noch im Band oder Nutzen ist und nach der Vereinzelung diese Zugriffsmöglichkeit unterbunden ist.

Die Aufgabe wird durch ein Substrat gemäß Anspruch 1, der gegen EP 0 671 705 A2 abgegrenzt ist, gelöst.

Hierdurch ist es möglich, den Halbleiterchip zu testen, solange das Trägerelement noch nicht aus dem Band oder dem Nutzen herausgetrennt ist. Die Ausnehmungen im Substrat erlauben einen Zugriff auf die Chipseite des Substrats von der Kontaktflächenseite her. Wenn das Trägerelement jedoch aus dem Band oder Nutzen getrennt ist, sind die Ausnehmungen nicht mehr Bestandteil des Trägerelements, da sie außerhalb dessen Außenkontur liegen. Somit ist beim vereinzelten Trägerelement kein Zugriff auf die Spulenanschlüsse des Halbleiterchips von der Kontaktflächenseite her mehr möglich. Wenn das Trägerelement in eine Karte eingebracht ist und somit ein Zugriff auf die Spulenanschlüsse nur noch kontaktlos über die angeschlossene Antenne möglich ist, kann von der Kontaktflächenseite her kein Abhören oder Stören bzw. kein elektrischer Zugriff oder eine Manipulation der kontaktlosen Datenübertragung erfolgen.

Um den Testzugriff auf die Spulenanschlüsse des Halbleiterchips möglichst einfach zu gestalten, können in vorteilhafter Weise die Ausnehmungen mit leitenden Flächen abgedeckt sein, die mit den Leiterstrukturen, mit denen der oder die Halbleiterchips und die Spule(n) verbunden werden, verbunden ist. Die Testspitzen können dann in einfacher Weise durch die Ausnehmungen hindurch auf die Fläche gesetzt werden.

Eine weitere Ausbildung sieht vor, die Ausnehmungen auf der Kontaktflächenseite des Substrats mit einer leitenden Fläche abzudecken, die über Durchkontaktierungen durch die Ausnehmungen hindurch mit den Leiterstrukturen auf der Chipseite des Substrats verbunden sind. Die Durchkontaktierungen können hierbei die Ausnehmungen ganz ausfüllen oder aber nur deren Wände bedecken.

Die Erfindung wird nachfolgend anhand eines Ausführungsbeispiels mit Hilfe von Figuren näher erläutert. Dabei zeigen:
- Figur 1: die Vorderansicht eines Ausschnittes aus einem Substratband und
- Figur 2: die Rückansicht eines Ausschnittes aus einem Substratband.

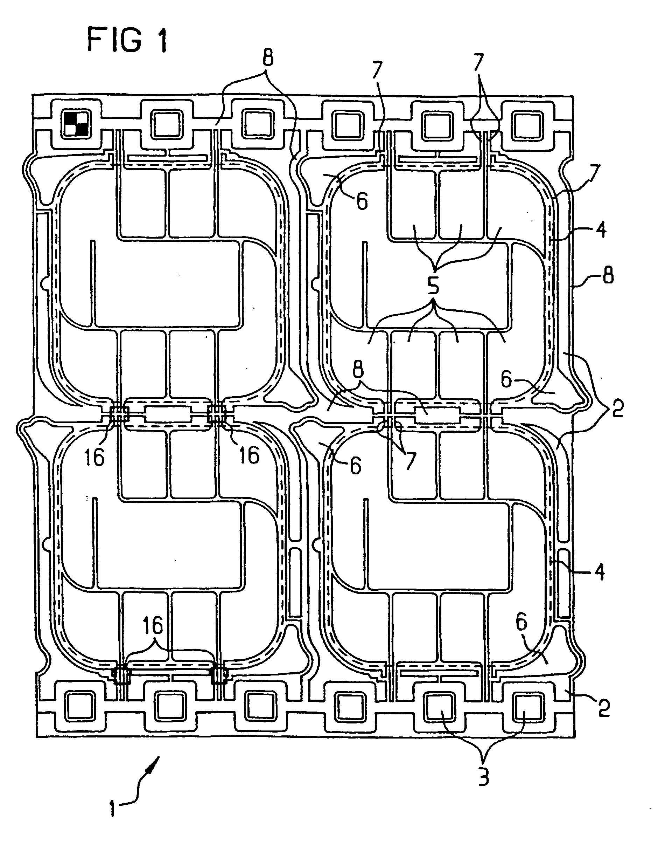

Die Figur 1 zeigt einen Ausschnitt aus einem Band 1, auf dem vier Trägerelemente paarweise ausgebildet sind. Es ist allerdings möglich, eine größere Anzahl als zwei Trägerelemente nebeneinander auf dem Band anzuordnen. Das Band besteht aus einem nicht-leitenden Substrat 2, wobei als Material beispielsweise glasfaserverstärktes Epoxidharz genommen werden kann.

Das Substrat 2 weist Perforationen 3 entlang beider Ränder auf, die dem Weitertransport mittels in die Perforationen 3 eingreifender Mitnehmer, beispielsweise bei der Bestückung des Bandes mit Halbleiterchips oder dem Funktionstest, dienen.

Die Außenkontur eines Trägerelements ist durch eine strichlierte Linie 4 angedeutet. Die fertig bestückten Trägerelemente werden entlang dieser Linie 4 aus dem Band 1 gestanzt oder sonstwie herausgetrennt.

Das nicht-leitende Substrat 2 wurde mit einer Metallfolie, vorzugsweise einer Kupferfolie, kaschiert. Durch anschließendes Ätzen wurde die Metallfolie strukturiert, so daß Kontaktflächen 5 innerhalb der Trägerelementaußenkonturlinie 4 sowie weitere Kontaktflächen 6, die außerhalb der Außenkonturlinie 4 des Trägerelements liegen, entstanden. Die Kontaktflächen 5, 6 sind über schmale Leitungen 7 mit um die Außenkonturlinien 4 herumlaufenden Leitungen 8 und somit alle miteinander verbunden. Dieser elektrische Kurzschluß ist nötig, da die Kontaktflächen 5, 6 galvanisch oberflächenveredelt werden.

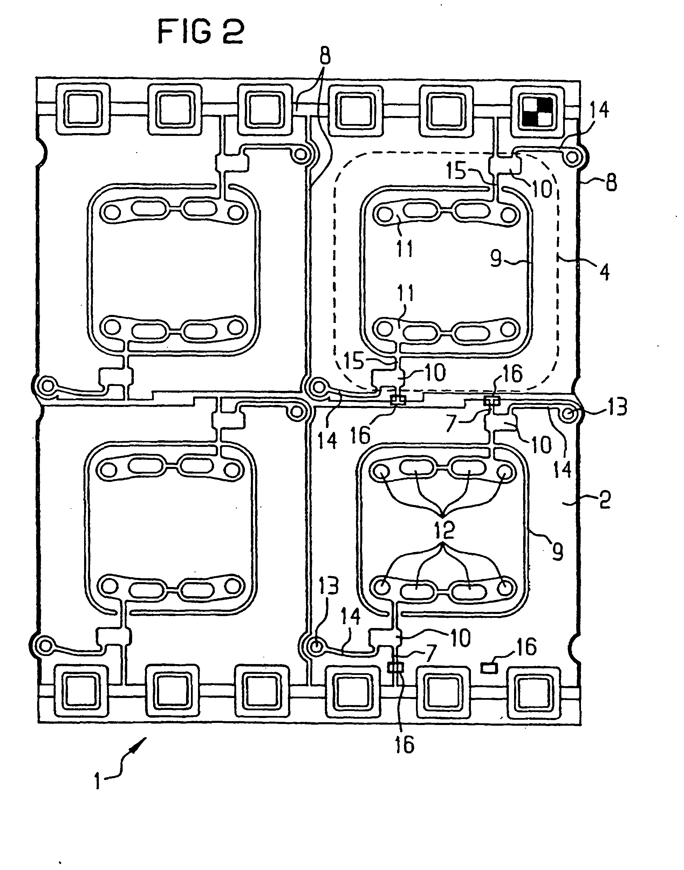

Figur 2 zeigt die andere Seite des Substrats 2, auf der der (nicht dargestellte) Halbleiterchip montiert wird. Auch diese Seite ist mit durch Metallfolienkaschieren und Ätzen entstandenen Leiterstrukturen 9, 10, 11, 14, 15 versehen.

Das Substrat wurde zunächst auf einer Seite mit einer Metallfolie kaschiert und anschließend mit Ausnehmungen 12, 13, die beispielsweise durch Stanzen erzeugt werden, versehen. Zum nachfolgenden Ätzen der Leiterstrukturen 9, 10, 14, 15 müssen die Ausnehmungen 12 abgedeckt werden, so daß um die Ausnehmungen 12 herum Metallisierungen 11 verbleiben, die zur Kontaktierung der Spulenanschlüsse eines Halbleiterchips genutzt werden können. Die Metallisierungen 11 bilden jeweils geschlossene leitende Ringe um die Ausnehmungen 12 herum. Zur Vermeidung mögicherweise auftretender Wirbelstromverluste können aber auch Unterbrechungen vorgesehen werden.

Von den Ausnehmungen 12, 13 liegen erste Ausnehmungen 12 innerhalb der Außenkonturlinie 4 und dienen der elektrischen Verbindung des Halbleiterchips mit den auf der anderen Seite des Substrats 2 liegenden Kontaktflächen 5 mittels Bonddrähte. Zweite Ausnehmungen 13 sind als Durchkontaktierungen ausgeführt, die die weiteren Kontaktflächen 6 über Leitungen 14 mit Spulenanschlußkontaktflächen 10 verbinden.

Das Substrat 4 ist relativ flexibel. In einer Chipkarte würde ein darauf montierter Halbleiterchip erheblichen Biegebelastungen ausgesetzt sein. Größere Chips würden sogar brechen. Aus diesem Grund wird ein (nicht dargestellter) Verstärkungsrahmen auf der Chipseite des Trägerelements mit einem Isolierkleber aufgeklebt. Der Verstärkungsrahmen ist vorzugsweise aus Metall, er kann aber auch aus einem anderen Material sein.

Da die Trägerelemente üblicherweise in die Chipkarte eingeklebt werden, muß entlang des Randes der Trägerelemente Platz für den Kleber sein, so daß der Verstärkungsrahmen nur knapp außerhalb des Bereichs der Bondlöcher 12 verläuft. Da außerdem das Innere des Verstärkungsrahmens zum Schutz des oder der darin angeordneten Halbleiterchips und der Bonddrähte mit einer Vergußmasse aufgefüllt wird, müssen Kontaktflächen 10 zum Anschluß einer Antennenspule für den kontaktlosen Betrieb des Halbleiterchips außerhalb des Verstärkungsrahmens liegen. Andererseits müssen Leiterstrukturen 15 vorgesehen sein, die unter dem Rahmen in dessen Inneres zur Verbindung mit dem Halbleiterchip verlaufen. Da der Rahmen auf diesen Leiterstrukturen 15 instabil zum Liegen käme, ist eine der Form des Rahmens entsprechende Metallisierung 9 zumindest gleicher Dicke wie die Leiterstrukturen 15 unterhalb des Verstärkungsrahmens auf dem Substrat 2 angeordnet.

Da dieser Metallisierungsring 9 und auch innerhalb des Rahmens liegende Kontaktfelder 11, mit denen die Spulenanschlüsse des Halbleiterchips über Bonddrähte verbunden werden und die dann über die Leiterstrukturen 15 mit den Spulenanschlußkontaktflächen 10 verbunden sind, parasitäre Kapazitäten darstellen, wird ihre Fläche so klein als möglich gewählt, um die Kapazität so klein als möglich zu halten.

Der Metallisierungsring 9 unter dem Verstärkungsrahmen darf nicht geschlossen sein, da sonst die Spulenenden kurzgeschlossen würden. Dadurch bilden sich jedoch zusätzliche parasitäre Kapazität zwischen den offenen Enden des Metallisierungsrings 9 und der oder den Leitungen 15 aus. Um diese Kapazitäten so gering wie möglich zu halten, ist der Spalt in dem Metallisierungsring unter dem Rahmen einerseits so groß wie möglich zu gestalten, andererseits aber nur so groß, daß die Vergußmasse nicht unter dem Rahmen herauslaufen kann.

Die auf dem Band oder dem Nutzen fertig montierten und gebondeten Halbleiterchips werden noch vor dem Vereinzeln auf dem Band oder dem Nutzen getestet. Da jedoch alle Kontaktflächen 5, 6 elektrisch über die schmalen Leitungen 7 und 8 miteinander verbunden sind, müssen diese Leitungen zuerst durchtrennt werden. Dies erfolgt durch Stanzen von Löchern 16. Diese sind aus Gründen der Übersichtlichkeit in den Figuren 1 und 2 nur an einem Trägerelement dargestellt.

Der Halbleiterchip läßt sich nun über die Kontaktflächen 5 wie im normalen Betrieb in einer Chipkarte testen. Der kontaktlose Betrieb läßt sich in erfindungsgemäßer Weise von der Kontaktflächenseite her über die weiteren Kontaktflächen 6, die über die Durchkontaktierungen 13 und die Leitungen 14 mit den Spulenanschlußkontaktflächen 10 verbunden sind, testen.

Nach dem Vereinzeln der Trägerelemente sind die Leitungen 14 durchtrennt und die Durchkontaktierungen 13 und die weiteren Kontaktflächen 6 nicht Bestandteile eines Trägerelements, so daß ein Zugriff von der Kontaktseite des Trägerelements auf die Spulenanschlüsse des Halbleiterchips nicht mehr möglich ist. Außerdem ist dann bei einem in eine Chipkarte eingesetzten Trägerelement ein Zugriff auf die Spulenanschlüsse nur noch über eine angeschlossene Antennenspule möglich.

Um die Spulenanschlüsse von der Kontaktseite her testen zu können, sind die weiteren Kontaktflächen 6 nicht unbedingt nötig. Es würde ausreichen, die Ausnehmungen mit leitendem Material zu füllen. Allerdings wäre dann die von Testspitzen zu kontaktierende Fläche deutlich kleiner.

Eine weitere Möglichkeit besteht darin, die Ausnehmungen 13 nicht als Durchkontaktierungen auszuführen, sondern sie statt dessen auf der Chipseite mit Kontaktflächen abzudecken. Die Testspitzen könnten dann durch die Ausnehmungen 13 hindurch mit diesen Kontaktflächen in Kontakt gebracht werden.

Allen Ausführungsvarianten ist jedoch gemeinsam, daß ein Zugriff auf die Spulenanschlüsse des Halbleiterchips von der Kontaktflächenseite her nur möglich ist, solange das Trägerelement noch nicht vereinzelt, sondern noch Bestandteil eines Bandes oder eines Nutzens ist.

## Patentansprüche

1. Nicht-leitendes, ein Band oder einen Nutzen bildendes Substrat (2), auf dem eine Vielzahl von Trägerelementen, insbesondere zum Einbau in eine Chipkarte, ausgebildet ist, indem die eine Kontaktflächenseite des Substrats (2) mit leitenden Kontaktflächen (5) versehen ist, die innerhalb einer die Größe eines Trägerelementes bestimmenden Außenkonturlinie (4) liegen,
**dadurch gekennzeichnet,**
**daß** eine der Kontaktflächenseite gegenüberliegende Seite des Substrats (2) mit Leiterstrukturen (9, 10, 11, 14, 15) versehen ist, die innerhalb der Außenkonturlinie (4) zumindest Kontaktfelder (11) für wenigstens eine zu kontaktierende Spule und wenigstens einen Halbleiterchip bilden,
**daß** auf der der Kontaktflächenseite gegenüberliegenden Seite des Substrats (2) außerhalb der Außenkonturlinie (4) Ausnehmungen (13) im Substrat (2) sind,
und **daß** von der Kontaktflächenseite zugängliche Mittel zum Verbinden mit den Kontaktfeldern (11) für wenigstens eine zu kontaktierende Spule ausgebildet sind, wobei diese Mittel zumindest durch die Ausnehmungen (13) hindurch oder als die Ausnehmungen (13) auf der der Kontaktflächenseite gegenüberliegenden Seite bedeckend ausgebildet sind.

2. Substrat nach Anspruch 1, **dadurch gekennzeichnet, daß** die Ausnehmungen (13) als mit den Leiterstrukturen (10, 11, 14, 15) verbundene Durchkontaktierungen ausgebildet sind und jeweils mit einer relativ kleinen zusätzlichen, außerhalb der Außenkonturlinie (4) auf der Kontaktflächenseite angeordneten Kontaktfläche (6) in Verbindung sind.

3. Substrat nach Anspruch 1, **dadurch gekennzeichnet, daß** auf der der Kontaktflächenseite gegenüberliegenden Seite die Ausnehmungen (13) durch jeweils eine leitende, mit den Leiterstrukturen (10, 11) verbundene Fläche abgedeckt sind.

4. Substrat nach Anspruch 1, **dadurch gekennzeichnet, daß** die Ausnehmungen (13) als mit den Leiterstrukturen (10, 11, 14, 15) verbundene Durchkontaktierungen ausgebildet sind und jeweils mit einer der Kontaktflächen (5) innerhalb der Außenkonturlinie (4) in Verbindung sind.

## Claims

1. Nonconductive substrate (2) which forms a strip or a panel and on which a plurality of carrier elements, in particular for installation in a chipcard, is formed, in which the one contact-face side of the substrate (2) is provided with conductive contact faces (5) which lie within an outer contour line (4) which determines the size of a carrier element, **characterized in that** a side, lying opposite the contact-face side, of the substrate (2) is provided with conductor structures (9, 10, 11, 14, 15) which form, within the outer contour line (4), at least contact fields (11) for at least one coil with which contact is to be made and at least one semiconductor chip, **in that** there are cut-outs (13) in the substrate (2) on the side of the substrate (2) lying opposite the contact-face side outside the outer contour line (4),
and **in that** means which are accessible from the contact face side and which are for the purpose of connecting to the contact fields (11) are formed for at least one coil with which contact is to be made, with this means being formed at least through the cut-outs (13) or as means which cover the cut-outs (13) on the side lying opposite the contact-face side.

2. Substrate according to Claim 1, **characterized in that** the cut-outs (13) are formed as plated-through interconnection holes which are connected to the conductor structures (10, 11, 14, 15) and are connected in each case to a relatively small additional contact face (6) which is arranged outside the outer contour line (4) on the contact-face side.

3. Substrate according to Claim 1, **characterized in that**, on the side lying opposite the contact-face side, the cut-outs (13) are covered by in each case one conductive face which is connected to the conductor structures (10, 11).

4. Substrate according to Claim 1, **characterized in that** the cut-outs (13) are formed as plated-through interconnection holes which are connected to the conductor structures (10, 11, 14, 15) and are connected in each case to one of the contact faces (5) within the outer contour line (4).

## Revendications

1. Substrat (2) non conducteur formant une bande ou un flan sur lequel est constituée une pluralité d'éléments de support à monter notamment dans une carte à puce, la face, ayant des surfaces de contact, du substrat (2) étant munie de surfaces (5) de contact conductrices qui se trouvent à l'intérieur d'une ligne (4) de contour extérieur déterminant la dimension d'un élément de support,
**caractérisé**
**en ce qu'**une face, opposée à la face ayant les surfaces de contact, du substrat (2) est munie de structures (9, 10, 11, 14, 15) conductrices qui forment à l'intérieur de ligne (4) de contour extérieur au moins des champs (11) de contact pour au moins une bobine à mettre en contact et pour au moins une puce à semi-conducteurs,
**en ce que**, sur la face, opposée à la face ayant les surfaces de contact, du substrat (2), des évidements (13) sont ménagés dans le substrat (2) à l'extérieur de la ligne (4) de contour extérieur,
et **en ce qu'**il est constitué des moyens accessibles par la face ayant les surfaces de contact de liaison aux champs (11) de contact pour au moins une bobine à mettre en contact, ces moyens étant formés au moins dans les ouvertures (13) ou recouvrant les ouvertures (13) sur la face opposée à la face ayant les surfaces de contact.

2. Substrat suivant la revendication 1, **caractérisé en ce que** les évidements (13) sont constitués sous la forme de contacts traversants reliés aux structures (10, 11, 14, 15) conductrices et étant, respectivement, en liaison avec une surface (6) de contact relativement petite supplémentaire à l'extérieur de la ligne (4) de contour extérieur et disposés sur la face ayant les surfaces de contact.

3. Substrat suivant la revendication 1, **caractérisé en ce que**, sur la face, opposée à la face ayant les surfaces de contact, les évidements (13) sont recouverts par, respectivement, une surface conductrice reliée aux structures (10, 11) conductrices.

4. Substrat suivant la revendication 1, **caractérisé en ce que** les évidements (13) sont constitués sous la forme de contacts traversants reliés aux structures (10, 11, 14, 15) conductrices et sont reliés, respectivement, à l'une des surfaces (5) de contact à l'intérieur de la ligne (4) de contour extérieur.
